# EUROPÄISCHE PATENTANMELDUNG

(11) **EP 1 561 839 A1**
(43) Veröffentlichungstag der Anmeldung: **10.08.2005**
(21) Anmeldenummer: 04001724.6
(22) Anmeldetag: 27.01.2004
(51) Int. Cl.: C23C 14/58, C23C 14/08, C23C 4/08, C23C 28/00, F01D 5/28, B23K 26/34

(54) **Verfahren zur Herstellung einer Schichtstruktur, enthaltend eine kolumnare, keramische Schicht**

(71) Anmelder: SIEMENS AKTIENGESELLSCHAFT, 80333 München (DE)
(72) Erfinder: Bostanjoglo, Georg Dr., 12161 Berlin (DE); Wilkenhöner, Rolf, Dr., 10589 Berlin (DE)

(57) **Zusammenfassung**

Keramische Schichten mit guten mechanischen Eigenschaften bei hohen Temperaturen sind nur aufwändig herzustellen.
Durch das erfindungsgemäße Verfahren wird eine keramische Schicht (10) hergestellt, die durch eine einfache Nachbehandlung, ausgehend von einer kostengünstig hergestellten Schichtstruktur, bezüglich ihrer mechanischen Eigenschaften erheblich verbessert wird. Dies geschieht durch eine Laserbehandlung, die eine dentritische Erstarrung des Materials der keramischen Schicht (10) bewirkt.

## Beschreibung

Die Erfindung betrifft ein Verfahren zur Herstellung einer Schichtstruktur, die aus einem Substrat und zumindest einer keramischen Schicht auf dem Substrat besteht, wobei die keramische Schicht zumindest teilweise eine kolumnare Struktur aufweist.

Aus dem Stand der Technik sind verschiedene Verfahren zum Herstellen einer Schichtstruktur bekannt. Auf ein Substrat können mehrere Schichten aufgebracht werden. Ausgehend von einem metallischen oder keramischen Substrat kann eine metallische Zwischenschicht vorhanden sein, auf die eine äußere keramische Schicht, beispielsweise eine Wärmedämmschicht, aufgebracht wird. Eine Wärmedämmschicht kann mittels eines Plasmaspritzverfahrens aufgebracht werden, wobei die Schicht eine granulare Struktur aufweist. Die Plasmaspritzverfahren APS, VPS, LPPS, stellen kostengünstige Beschichtungsmethoden dar.

Bessere mechanische Eigenschaften weist eine kolumnare Struktur einer keramischen Schicht auf, die aus einzelnen Stängeln besteht, die beispielsweise mittels eines Elektronenstrahls (EB-PVD (physical vapour deposition)-Verfahren hergestellt wird. Dieses Verfahren ist relativ teuer und zeitintensiv.

Aus der US-PS 5,576,069 ist ein Prozess bekannt, bei dem eine plasmagespritzte Zirkonoxidschicht durch einen Laser aufgeschmolzen wird. Das Aufschmelzen wird durchgeführt, um Risse und Poren, insbesondere durch Auffüllen mit zusätzlichem Material, zu verschließen.

Die US-PS 5,897,921 und die US-PS 5,989,343 zeigen ein Verfahren, bei dem mittels Plasmaspritzen eine keramische Schicht mit einer gerichteten Struktur erzeugt wird.

Die US-PS 5,830,586 und die US-PS 6,180,184 B1 offenbaren ebenfalls ein Verfahren zur Herstellung einer keramischen Schicht mit einer gerichteten Struktur mittels Plasmaspritzverfahren.

Die EP 1 340 583 A1 offenbart ein Verfahren zum Auftragsschweißen eines Bauteils aus einer nickel- oder kobaltbasierten Superlegierung.

Es ist Aufgabe der Erfindung ein Verfahren aufzuzeigen, das eine keramische Schicht ergibt, die einfacher und kostengünstiger und mit guten mechanischen Eigenschaften herzustellen ist.

Die Aufgabe wird gelöst durch ein Verfahren zur Herstellung einer Schichtstruktur gemäß Anspruch 1.

In den Unteransprüchen sind weitere vorteilhafte Verfahrensschritte aufgelistet.
Die in den Unteransprüchen aufgelisteten Maßnahmen können in sinnvoller Art und Weise miteinander kombiniert werden.

Es zeigen
- Figur 1: eine Schichtstruktur nach dem Stand der Technik, die als Ausgangsstruktur für das Verfahren verwendet wird,
- Figur 2: einen Verfahrensschritt des erfindunsgemäßen Verfahrens,
- Figur 3: eine Schichtstruktur, die mittels des erfindungsgemäßen Verfahrens hergestellt worden ist,
- Figur 4: eine Aufsicht auf eine keramische Wärmedämmschicht, die mittels des erfindungsgemäßen Verfahrens hergestellt worden ist,
- Figur 5: einen ersten Verfahrensschritt einer weiteren Ausführungsform des erfindungsgemäßen Verfahrens,
- Figur 6: einen weiteren Verfahrensschritt eines weiteren Ausführungsbeispiels des erfindungsgemäßen Verfahrens,
- Figur 7: eine Gasturbine,
- Figur 8: eine Turbinenschaufel,
- Figur 9: eine Brennkammer.

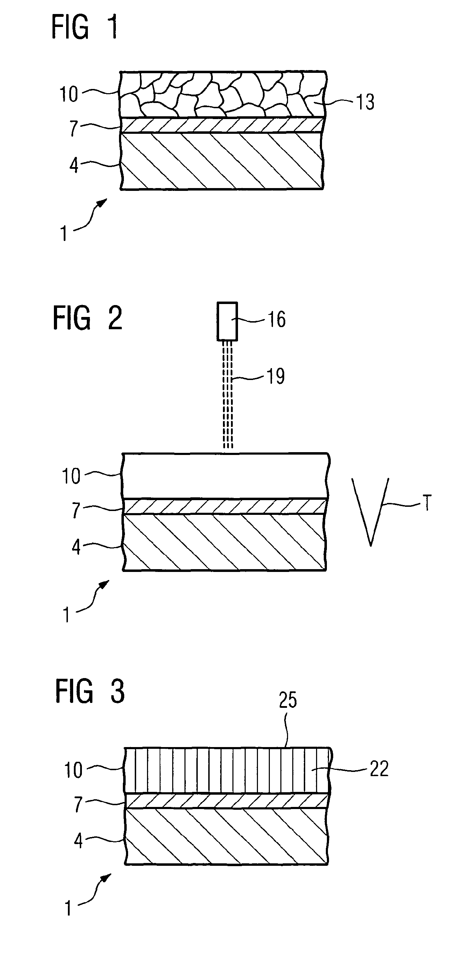

Figur 1 zeigt eine Schichtstruktur 1, die aus einem Substrat 4 besteht.
Das Substrat 4 ist beispielsweise keramisch oder metallisch, insbesondere eine eisen-, nickel- oder kobaltbasierte Superlegierung für ein Turbinenbauteil.

Auf dem Substrat 4 ist beispielsweise zumindest eine Zwischenschicht 7 aufgebracht. Die Zwischenschicht 7 kann keramisch oder metallisch sein, insbesondere eine MCrAlX-Schicht, wobei M für zumindest ein Element der Gruppe Eisen, Kobalt oder Nickel steht und X Yttrium, Silizium und/oder zumindest ein Element der Seltenen Erden, also ein Aktivelement darstellt.

Auf der Zwischenschicht 7 ist eine keramische äußere Schicht 10 (beispielsweise eine Wärmedämmschicht) aufgebracht. Die Schicht 10 kann auch metallisch sein.
Die Schicht 10 ist beispielsweise durch ein Plasmaspritzverfahren, wie z.B. atmosphärisches Plasmaspritzen (APS), Vakuumplasmaspritzen (VPS) oder Niedrigdruckplasmaspritzen (LPPS) aufgebracht worden. Weitere Beschichtungsarten sind denkbar (Schlickerauftragung).

Eine solche plasmagespritzte Schicht 10 besitzt eine granulare Struktur, d.h. sie besteht aus vielen einzelnen Körnern 13, die nicht aufeinander ausgerichtet sind.

Eine solche granulare Struktur weist gegenüber einer Struktur mit stängelförmigen, d.h. kolumnar ausgerichteten Körnern schlechtere mechanische Eigenschaften auf.
Daher wird ausgehend von einer Schichtstruktur 1 gemäß Figur 1 die Schichtstruktur 1 erfindungsgemäß mit zumindest einem Laser 16 zumindest stellenweise umgewandelt (Fig. 2).

Der Laser 16 mit seinen Laserstrahlen 19 (Fig. 2) wirkt dabei auf die keramische Schicht 10 ein und schmilzt die keramische Schicht 10 zumindest teilweise auf. Durch Gewährleistung eines ausreichend hohen Temperaturgradienten zum Substrat 4 hin erstarrt das Material der keramischen Schicht 10 dendritisch in einer kolumnaren Struktur oder einkristallin. Der Temperaturgradient weist an der keramischen Schicht 10 die höchste Temperatur T und hin zum Substrat 4 eine geringe Temperatur T auf. Der Temperaturgradient stellt sich ein durch die Wärmzufuhr des Lasers 16 in die keramische Schicht 10 und kann auch durch zusätzliche Wärmezufuhr oder Kühlung des Substrats 4 auch während des Verfahrens eingestellt und kontrolliert werden.

Die keramische Schicht 10 kann lokal oder global, d.h. über die ganze Oberfläche des Substrats 4, behandelt werden.

Figur 3 zeigt im Querschnitt eine Schichtstruktur 1, die mittels des erfindungsgemäßen Verfahrens behandelt worden ist.

Die keramische Schicht 10 weist jetzt beispielsweise komplett eine stängelförmige (kolumnare) Struktur (Körner) 22 auf, die sich entlang des Temperaturgradienten (Fig. 2) ausgebildet haben. Die Schicht 10 kann auch einkristallin, insbesondere wenn sie metallisch ist, hergestellt werden.

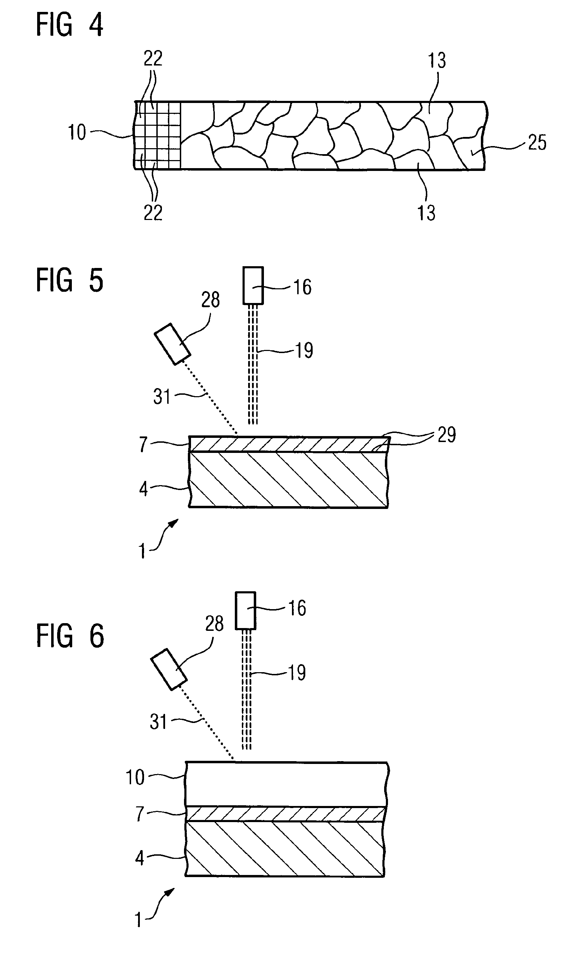

Figur 4 zeigt eine Aufsicht auf eine Oberfläche 25 der keramischen Schicht 10.
Durch eine stellenweise, also lokale Behandlung der keramischen Schicht 10 weist die keramische Schicht Bereiche mit granularen Körnern 13 und kolumnaren Körnern 22 auf. Die Ausdehnung der behandelten Oberfläche und die Stellen können je nach mechanischen und/oder thermischen Anforderungsbedingungen der Schichtstruktur 1 eines Bauteils eingestellt werden, wie es aus der EP 1 123 455 bekannt ist, die Bestandteil dieser Offenbarung ist.

So kann auch die Porosität der Schicht 10, die zum Teil die thermomechanischen Eigenschaften bestimmt, zumindest stellenweise (lateral, vertikal) unterschiedlich sein, um das Thermoschockverhalten zu beeinflussen.
Die Porosität kann durch Parameter des Lasers 16 eingestellt werden.
Ebenso kann eine kolumnare Struktur 22 auf einer porösen Struktur vorhanden sein.

Die Figuren 5, 6 zeigen ein weiteres Ausführungsbeispiel des erfindungsgemäßen Verfahrens.

Hier ist noch keine Schicht 10 vorhanden, die umgewandelt wird, sondern es wird Material 31 für die keramische Schicht 10 beispielsweise direkt auf das Substrat 4 oder eine bereits vorhandene Zwischenschicht 7 aufgebracht. Das Material 31 wird beispielsweise über einen Materialförderer 28 der Oberfläche 29 der Zwischenschicht 7 oder des Substrats 4 zugeführt. Gleichzeitig oder anschließend wird das Material 31 mittels der Laserstrahlen 19 des Lasers 16 verdichtet. Dies geschieht dadurch, dass das Material 31 durch die Laserstrahlen 19 (oder Elektronenstrahlen) zumindest teilweise aufgeschmolzen und direkt dendritisch oder einkristallin erstarren gelassen wird. Dies kann stellenweise (Fig. 4) oder für die gesamte (Fig. 3) Schicht 10 erfolgen.
Das Material 31 kann auch Polymere (Kunststoffe) enthalten, die Poren in der Schicht 10 erzeugen.

Die Schicht 10 wird beispielsweise schichtweise durch mehrmaliges Überfahren und Zufuhr von Material 31 aufgebaut.

Dendritische oder gerichtet erstarrte Strukturen wachsen stets in Richtung der schnellsten Wärmeabfuhr. Eine schnelle Wärmeabfuhr erfolgt insbesondere nach der Laserbestrahlung, da durch den Laser relativ dünne Schichten aufschmelzbar sind und die nicht aufgeschmolzenen tieferen Schichten schnell Wärme aufnehmen und somit aus dem Schmelzbereich abziehen können. Daher kann der Temperaturgradient zum Substrat 4 durch zusätzliche Erwärmung und/oder Kühlung am Substrat 4 eingestellt und kontrolliert werden.

Ebenso kann auch die Zwischenschicht 7 (McrAlX-Schicht) mittels eines Laserverfahrens auf das Substrat 4 aufgebracht werden. Somit kann sowohl die Zwischenschicht 7 als auch die keramische Schicht in ein und derselben Apparatur aufgetragen werden.

Ebenso kann das Substrat 4, wenn es z.B. Risse aufweist, wie in der EP 1 340 583 A1 allgemein beschrieben, durch Auftragsschweißen repariert werden, insbesondere bevor in derselben Apparatur weitere Schichten 7, 10 aufgebracht werden.

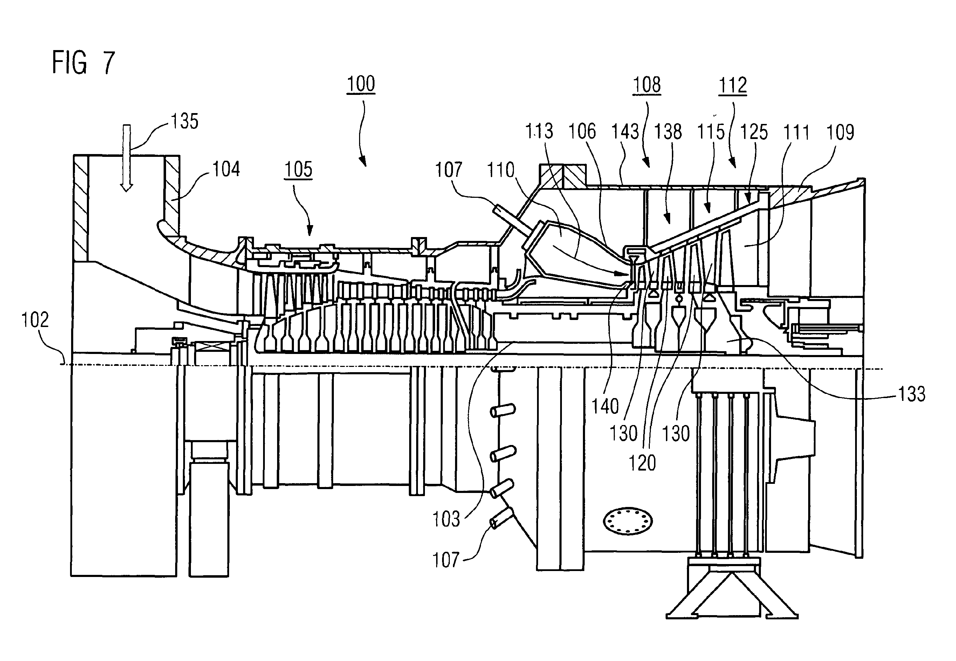

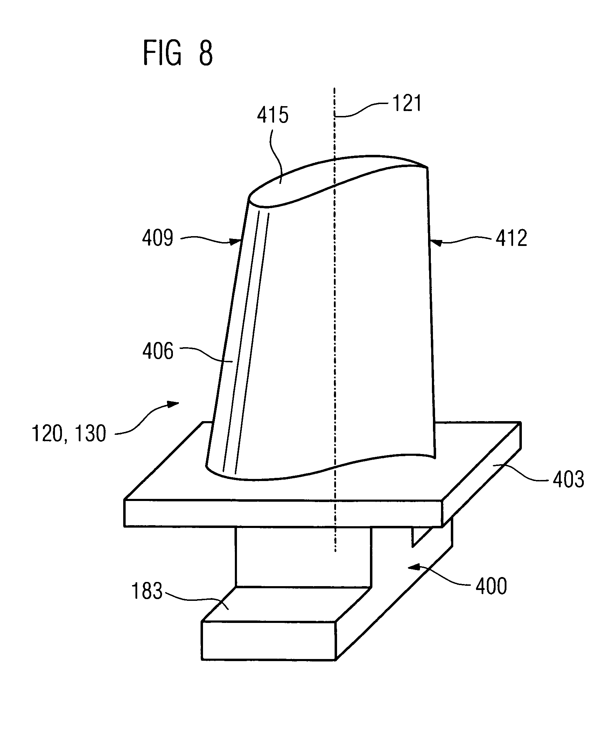

Insbesondere findet eine erfindungsgemäß erzeugte Schichtstruktur 1 Anwendung bei Turbinenbauteilen (Gasturbine 100 (Fig. 7), Dampfturbine) wie z.B. bei Schaufeln 120, 130, Brennkammerauskleidungen 155 (Fig. 8), die entweder neu hergestellt oder wieder aufgearbeitet werden.

Die Figur 7 zeigt eine Gasturbine 100 in einem Längsteilschnitt.

Die Gasturbine 100 weist im Inneren einen um eine Rotationsachse 102 drehgelagerten Rotor 103 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109.
Die Ringbrennkammer 106 kommuniziert mit einem beispielsweise ringförmigen Heißgaskanal 111. Dort bilden beispielsweise vier hintereinandergeschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1204776, EP 1306454, EP 1319729, WO 99/67435 oder WO 00/44949 bekannt; diese Schriften sind Teil der Offenbarung.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden) und Wärme durch eine Wärmedämmschicht aufweisen.
Die Wärmedämmschicht besteht beispielsweise ZrO₂, Y₂O₄-ZrO₂, d.h. sie ist nicht, teilweise oder vollständig stabilisiert durch Yttriumoxid und/oder Kalziumoxid und/oder Magnesiumoxid.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Figur 8 zeigt in perspektivischer Ansicht eine Schaufel 120, 130, die sich entlang einer Längsachse 121 erstreckt.

Die Schaufel 120 kann eine Laufschaufel 120 oder Leitschaufel 130 einer Strömungsmaschine sein. Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf.
Als Leitschaufel 130 kann die Schaufel an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe verwendet.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher (nicht dargestellt) auf. Als Schutz gegen Korrosion weist die Schaufel 120, 130 beispielsweise entsprechende meistens metallische Beschichtungen auf und als Schutz gegen Wärme meistens noch eine keramische Beschichtung.

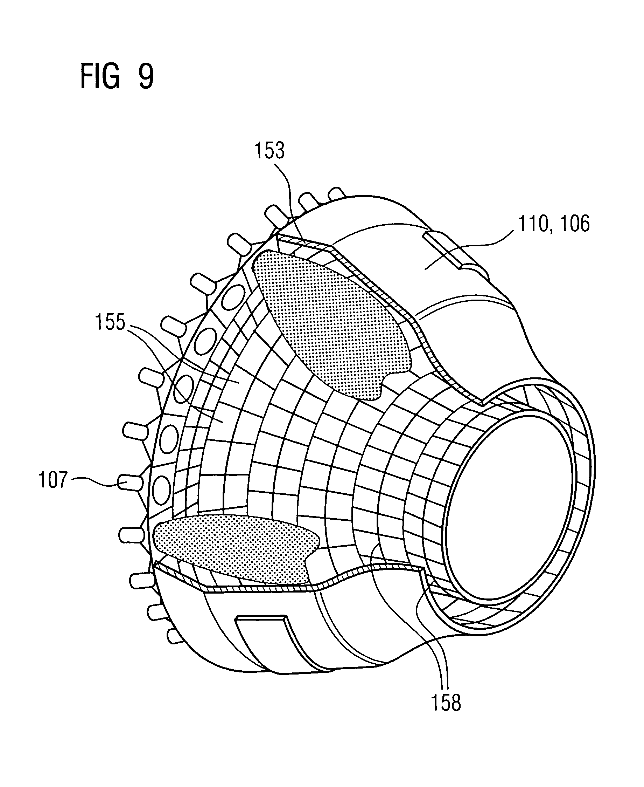

Die Figur 9 zeigt eine Brennkammer 110.
Die Brennkammer 110 ist beispielsweise als so genannte Ringbrennkammer ausgestaltet, bei der eine Vielzahl von in Umfangsrichtung um die Turbinenwelle 103 herum angeordneten Brennern 102 in einen gemeinsamen Brennkammerraum münden. Dazu ist die Brennkammer 110 in ihrer Gesamtheit als ringförmige Struktur ausgestaltet, die um die Turbinenwelle 103 herum positioniert ist.

Zur Erzielung eines vergleichsweise hohen Wirkungsgrades ist die Brennkammer 110 für eine vergleichsweise hohe Temperatur des Arbeitsmediums M von etwa 1000(C bis 1600(C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen. Jedes Hitzeschildelement 155 ist arbeitsmediumsseitig mit einer besonders hitzebeständigen Schutzschicht ausgestattet oder aus hochtemperaturbeständigem Material gefertigt, wie sie von Turbinenschaufeln 120, 130 bekannt sind. Aufgrund der hohen Temperaturen im Inneren der Brennkammer 110 ist zudem für die Hitzeschildelemente 155 bzw. für deren Halteelemente ein Kühlsystem vorgesehen.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

## Patentansprüche

1. Verfahren zur Herstellung einer Schichtstruktur (1), zumindest bestehend aus
einem Substrat (4),
zumindest einer keramischen Schicht (10) auf dem Substrat (4),
bei der zumindest ein Laser (16) verwendet wird,
um zumindest stellenweise in der keramischen Schicht (10) eine zumindest kolumnare Struktur (22) zu erzeugen.

2. Verfahren nach Anspruch 1,
**dadurch gekennzeichnet, dass**
eine keramische Schicht (10) bereits auf dem Substrat (4) vorhanden ist
und mit dem Laser (16) so behandelt wird,
insbesondere durch Umschmelzen,
dass die zumindest kolumnare Struktur (22) entsteht.

3. Verfahren nach Anspruch 2,
**dadurch gekennzeichnet, dass**
die keramische Schicht (10) durch ein Plasmaspritzverfahren (APS, LPPS, VPS, ...) auf das Substrat (4) aufgebracht wurde, bevor sie (10) mit dem Laser behandelt wird.

4. Verfahren nach Anspruch 1,
**dadurch gekennzeichnet, dass**
dass Material (31) für die keramische Schicht (10) dem Substrat (4) zugeführt wird und
dass das Material (31) durch den Laser (16) aufgeschmolzen und zumindest stellenweise die zumindest kolumnare Struktur (22) erzeugt wird.

5. Verfahren nach Anspruch 1, 2 oder 4,
**dadurch gekennzeichnet, dass**
die zumindest kolumnare Struktur (22) der keramischen Schicht (10) nur stellenweise auf dem Substrat (4) ausgebildet wird.

6. Verfahren nach Anspruch 1 bis 4,
**dadurch gekennzeichnet, dass**
die zumindest kolumnare Struktur (22) der keramischen Schicht (10) auf der gesamten Kontaktfläche zwischen Substrat (4) und Schicht (10) ausgebildet wird.

7. Verfahren nach Anspruch 1,
**dadurch gekennzeichnet, dass**
als Substrat (4) eine eisen-, nickel- oder kobaltbasierte Superlegierung verwendet wird.

8. Verfahren nach Anspruch 1,
**dadurch gekennzeichnet, dass**
die Schicht (10) eine keramische Wärmedämmschicht ist.

9. Verfahren nach Anspruch 8,
**dadurch gekennzeichnet, dass**
die Schicht (10) Zirkonoxid (ZrO₂),
insbesondere 8 wt% Y₂O₃-ZrO₂ enthält.

10. Verfahren nach Anspruch 1, 8 oder 9,
**dadurch gekennzeichnet, dass**
die Porosität der Schicht (10) zumindest stellenweise variiert wird.

11. Verfahren nach Anspruch 1, 8 oder 9.
**dadurch gekennzeichnet, dass**
die Struktur (22) einkristallin erzeugt wird.

12. Verfahren nach Anspruch 1, 8 oder 9,
**dadurch gekennzeichnet, dass**
vor dem Aufbringen der keramischen Schicht (10) eine Zwischenschicht (7),
insbesondere eine MCrAlX (M = Ni, Fe, Co, X = Y und/oder Element der Seltenen Erden),
insbesondere mittels eines Lasers (16),
auf das Substrat (4) aufgebracht wird.

13. Verfahren nach Anspruch 12,
**dadurch gekennzeichnet, dass**
die Zwischenschicht (7) in der gleichen Apparatur wie die keramische Schicht (10) hergestellt wird.

14. Verfahren nach Anspruch 1,
**dadurch gekennzeichnet, dass**
die Schichtstruktur (1) auf einem Bauteil (20), insbesondere auf einer Turbinenschaufel (120, 130) oder einer Brennkammerauskleidung (155) einer Turbine, insbesondere einer Dampf- oder einer Gasturbine (100) erzeugt wird.

15. Verfahren nach Anspruch 14,
**dadurch gekennzeichnet, dass**
als Bauteil (20) ein neu hergestelltes Bauteil eingesetzt wird.

16. Verfahren nach Anspruch 14,
**dadurch gekennzeichnet, dass**
als Bauteil (20) ein wieder aufgearbeitetes Bauteil eingesetzt wird.
